# EUROPEAN PATENT SPECIFICATION

(11) **EP 1 752 882 B1**
(45) Date of publication and mention of the grant of the patent: **23.08.2017**
(21) Application number: 06014349.2
(22) Date of filing: 11.07.2006
(51) Int. Cl.: G06F 13/40

(54) **Circuitry and methods for programmably adjusting the duty cycles of serial data signals**
Schaltung und Verfahren zur programmierbaren Einstellung des Tastverhältnisses serieller Datensignale
Circuit électrique et procédés d'ajustement programmable des cycles de travail des signaux de données en série

(30) Priority: 28.07.2005 US 193146
(43) Date of publication of application: 14.02.2007
(73) Proprietor: ALTERA CORPORATION, San Jose, CA 95134 (US)
(72) Inventor: Shumarayev, Sergey Yuryevich, Los Altos Hills California 94022 (US); Patel, Rakesh, Cupertino California 95014 (US)
(74) Representative: Appelt, Christian W.

(56) References cited:
- EP-A- 0 398 751
- EP-A- 1 146 644
- GB-A- 2 377 102
- US-A- 5 698 991
- US-A1- 2002 173 925

## Description

### Background of the Invention

The present invention relates to serial data transmission. More particularly, this invention relates to serial I/O circuitry with programmable duty cycle adjustment.

Duty cycle distortion is a type of jitter that affects serial data transmission systems. When a data signal is transmitted across a transmission medium (e.g., a backplane), the duty cycle of the data signal becomes distorted. For example, a data signal may be transmitted with a 45/55 duty cycle, but after traveling across the transmission medium the duty cycle of the data signal may further distort to 40/50.

The magnitude of duty cycle distortion is a function of the data rate of the data signal. In particular, as the data rate of the data signal increases, duty cycle distortion becomes more pronounced. One reason that duty cycle distortion is data rate dependent is because the pulse widths of data signals become smaller as the data rate increases. Other forms of jitter, such as, for example, attenuation and channel pulse width dispersion, are also data rate dependent.

By not correcting duty cycle distortion, the received data signal may be misinterpreted, leading to occurrences of bit errors. For example, as a result of duty cycle distortion, a receiver may misinterpret a "0" in the data signal as a "1" or vice versa.

GB-A-2 377 102 discloses a programmable differential CMOS USB bus driver which allows trimming of crossover voltage to counteract manufacturing variations. The differential CMOS USB driver produces complementary output signals DP, DM in response to the data input signal TXD. Correct crossover of the output signals DP and DM can be obtained by selectively delaying either the leading or trailing edge of the input signal TXD by a variable amount to generate signals DTXP and DTXM. The drive signal generators provide phased drive signals UPP/DNP or UPM/DNM to prevent shoot-through current in the output drivers. A crossover voltage complying with USB standard V 1:1 may be obtained despite manufacturing variations affecting rise and fall times.

### Summary of the Invention

The invention is defined by the subject matter of independent claims 1 and 9. Advantageous embodiments of the invention are subject to the dependent claims.

Programmable duty cycle adjustment circuitry may be provided to correct duty cycle distortion for a data signal caused by a transmission medium. Programmable duty cycle adjustment circuitry may be implemented on drivers and/or receivers.

Programmable duty cycle adjustment circuitry implemented on drivers may seek to adjust the duty cycle of data signals to be 50/50. In some embodiments, drivers may also superimpose preemphasis or deemphasis signals on the data signals, which affects the duty cycles of the data signals. When providing duty cycle adjustment to the data signals, the programmable duty cycle adjustment circuitry may take into account the amount of preemphasis or deemphasis provided to the data signals.

Programmable duty cycle adjustment circuitry implemented on receivers may seek to adjust the duty cycle of data signals to be 50/50. When implemented on receivers, the programmable duty cycle adjustment circuitry is correcting for duty cycle distortion on data signals that has already occurred. As such, the programmable duty cycle adjustment circuitry may have to provide more duty cycle adjustment that programmable duty cycle adjustment circuitry implemented on drivers.

Programmable duty cycle adjustment circuitry may perform duty cycle adjustment by shifting the rising and falling edges of data signals. For example, the programmable duty cycle adjustment circuitry may shift the rising and falling edges of the positive and negative legs of the data signals until the data signals have duty cycles of 50/50.

Programmable duty cycle adjustment circuitry may also be configured to adjust the common mode levels of data signals. For example, the high and low levels of the data signals may be shifted upwards or downwards to provide the data signals with higher or lower common mode levels.

The programmable duty cycle adjustment circuitry may allow end-users to determine the amount of duty cycle adjustment to provide data signals. For example, end-users may measure the amount of duty cycle distortion on a data signal and configure programmable duty cycle adjustment circuitry to correct the duty cycle of the data signal. In another example, end-users may couple a bit error rate counter to the receiver and determine the amount of duty cycle adjustment to provide the data signal that results in the lowest bit error rate count.

The programmable duty cycle adjustment circuitry may dynamically determine the amount of duty cycle adjustment to provide data signals. For example, programmable duty cycle adjustment circuitry may include a negative feedback loop.

Further features of the invention, its nature and various advantages will be more apparent from the accompanying drawings and the following detailed description of the preferred embodiments.

### Brief Description of the Drawings

FIG. 1 is a block diagram of an illustrative serial data transmission system in accordance with the present invention.
FIG. 2A is a waveform diagram of a differential signal with a 50/50 duty cycle.
FIG. 2B is a waveform diagram of a differential signal with duty cycle distortion.
FIG. 2C is a waveform diagram that illustrates the effects of preemphasis on the duty cycle of a differential signal.
FIG. 3 is a block diagram of an illustrative driver that has the capability to adjust the duty cycles of data signals in accordance with the present invention.
FIG. 4 is a block diagram of an illustrative receiver that has the capability to adjust the duty cycles of data signals in accordance with the present invention.
FIG. 5 is a diagram that illustrates the ability of programmable duty cycle adjustment circuitry to adjust a differential signal in accordance with the present invention.

### Detailed Description of the Preferred Embodiments

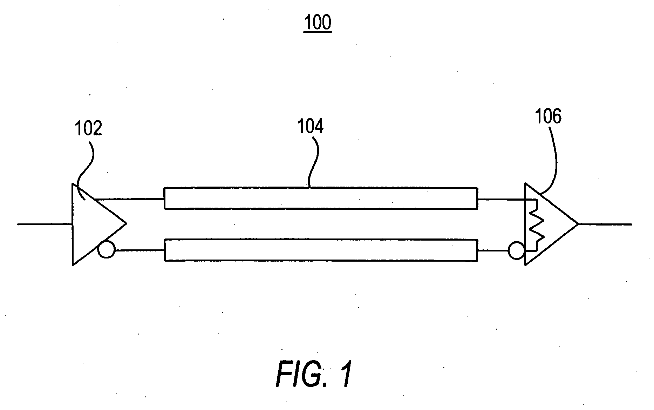

FIG. 1 is a block diagram of an illustrative serial data transmission system 100 in accordance with the present invention. System 100 may include a driver 102, a transmission medium 104, and a receiver 106. System 100 may be used to transmit serial data from driver 102 to receiver 106 using any suitable serial transmission protocol, including, for example, low-voltage differential signaling (LVDS), pseudo current mode logic (PCML), pseudo emitter-coupled logic (PECL), and low-voltage pseudo emitter-coupled logic (LVPECL).

Driver 102 may be part of a device configured to transmit serial data signals. For example, driver 102 may be part of a programmable logic device (PLD), a high-speed serial interface (HSSI), an application-specific integrated circuit (ASIC), and any other device that transmits serial data signals. In some embodiments, driver 102 may be referred to as a transmit (Tx) buffer. In some embodiments, driver 102 may utilize clock data signaling by embedding clock information in the data signal so that no separate clock information needs to be transmitted.

In some embodiments, driver 102 may provide preemphasis to the data signals being transmitted, which compensates for the attenuation of the high-frequency signal components of the data signals. The preemphasis, which is a relatively small amount of extra signal superimposed on top of the regular signal at the edges of each digital data bit, helps to offset high-frequency attenuation effects, thereby producing less attenuated and cleaner signals. Preemphasis is discussed in greater detail in Shumarayev et al. U.S. Patent Application No. 10/338,921, filed January 7, 2003, which is hereby incorporated by reference herein in its entirety.

In some embodiments, driver 102 may provide deemphasis to the data signals being transmitted. Deemphasis is another technique that may be used to offset high-frequency attenuation effects. Deemphasis works by suppressing the data signal except at the edges of each digital bit.

Transmission medium 104 may carry data from driver 102 to receiver 106. Transmission medium 104 may be any suitable medium, such as, for example, a printed circuit board backplane, a transmission line, a cable, air (i.e., for wireless applications), or any other suitable medium.

Generally, data signals traveling across transmission medium 104 experience duty cycle distortion, in which the duty cycle of the data signal becomes more distorted than when it was transmitted. Duty cycle distortion may be minimized by transmitting data signals with 50/50 duty cycles.

Receiver 106 may be configured to receive and process data transmitted by driver 102 across transmission medium 104. Receiver 106 may be a component of a device, such as, for example, a programmable logic device, a transceiver, a high-speed serial interface, an application-specific integrated circuit (ASIC), or any other suitable device.

Receiver 106 may include a termination resistor that is matched to the impedance of transmission medium 104 to prevent reflections and signal loss from occurring. The resistance of the termination resistor may be programmable to allow transmission media having various impedances to be used with receiver 106. In some embodiments, receiver 106 may include clock data recovery (CDR) circuitry for separating data signals transmitted by driver 102 into data components and clock components. In some embodiments, receiver 106 may include equalization circuitry that compensates for attenuation caused by transmission medium 104.

Driver 102 and receiver 106 may also include circuitry for programmably adjusting the duty cycle of transmitted and received data signals, respectively. Data signals that are not transmitted with a 50/50 duty cycle may experience duty cycle distortion, which increases the likelihood that a bit error will occur. Allowing driver 102 and/or receiver 106 to adjust the duty cycle of data signals may minimize the duty cycle distortion, thereby reducing the number of bit errors. Duty cycle adjustment circuitry will be discussed in greater detail hereinbelow.

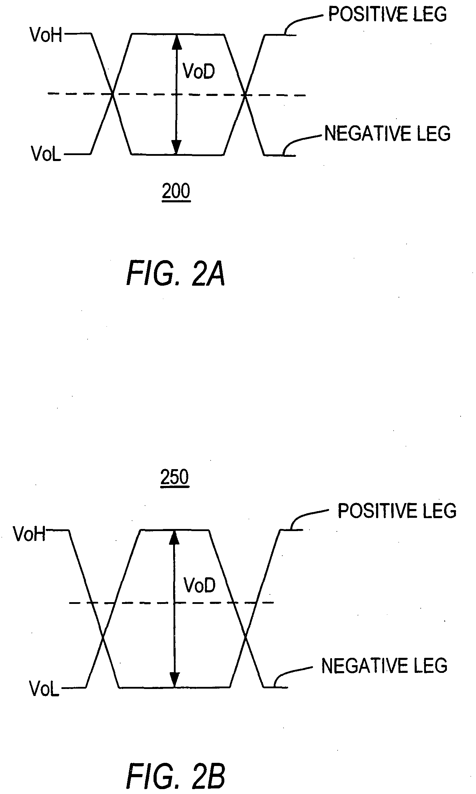

FIG. 2A is a waveform diagram of a data signal 200 with a 50/50 duty cycle. Ideally, driver 102 transmits all data signals with 50/50 duty cycles because by doing so, duty cycle distortions are minimized. However, data signals with 50/50 duty cycles are difficult to generate, especially at the higher data rates at which current systems operate. Also, driver 102 may be unable to generate data signals with 50/50 duty cycles because of process variations that skew the output of driver 102. The use of preemphasis or deemphasis may also affect the duty cycle of data signals because preemphasis and deemphasis alter the pulse width of data signals.

As shown in FIG. 2A, a key trait of data signal 200 (and of all data signals with 50/50 duty cycles) is that the positive and negative legs of data signal 200 cross at the vertical midpoint between V_{OH} and V_{OL}. As a result, the positive and negative legs of data signal 200 mirror one another regardless of the bit values in data signal 200.

FIG. 2B is a waveform diagram of a data signal 250 with duty cycle distortion. If driver 102 (FIG. 1) were to transmit data signal 250, the duty cycle of the data signal would become further distorted from traveling across transmission medium 104 (FIG. 1). This may lead to receiver 106 (FIG. 1) erroneously interpreting the bit values in data signal 250.

As shown in FIG. 2B, the positive and negative legs of data signal 250 do not cross at vertical midpoint between V_{OH} and V_{OL}. In particular, the positive and negative legs of data signal 250 cross at a much lower voltage. As a result, the positive and negative legs of data signal 250 do not mirror one another.

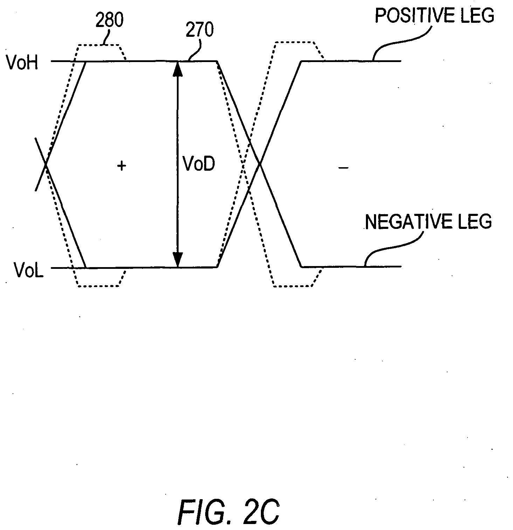

FIG. 2C is a waveform diagram that illustrates the effects of preemphasis on the duty cycle of a differential signal. As shown in FIG. 2C, data signals 270 and 280 are identical except that data signal 280 includes preemphasis to compensate for high-frequency attenuation of data signal 280. The preemphasis affects the pulse width of data signal 280, which in turn affects the duty cycle of data signal 280. Accordingly, when adjusting the duty cycle of a data signal being transmitted, it is important to consider whether the data signal includes preemphasis. Providing deemphasis to data signals affects the duty cycles of data signals in a similar manner.

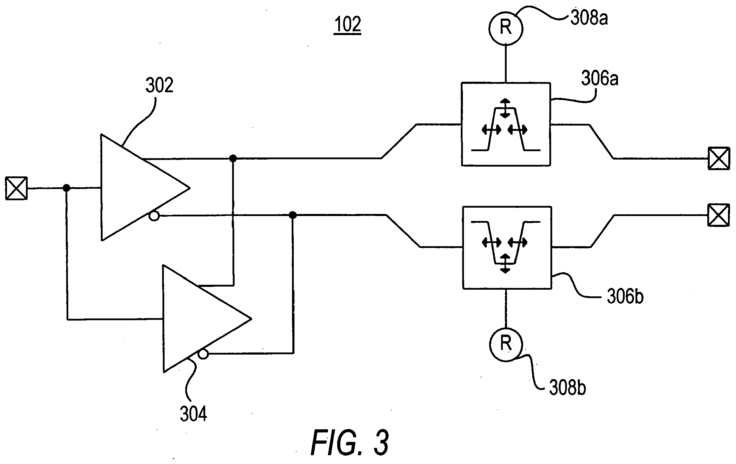

FIG. 3 is a block diagram of an illustrative driver 102 that has the capability to adjust the duty cycles of data signals in accordance with the present invention. Driver 102 may include primary driver 302, preemphasis driver 304, programmable duty cycle circuitry 306a and 306b, and memory elements 308a and 308b.

Primary driver 302 may generate the data signal. In some embodiments, the data signal generated by primary driver 302 conforms to a differential signaling standard. In some embodiments, the data signal generated by primary driver 302 conforms to a single-ended signaling standard.

Preemphasis driver 304 may generate a preemphasis signal to be superimposed upon the data signal generated by primary driver 302. In some embodiments, preemphasis driver 304 may be programmable. For example, a user may configure preemphasis driver 304 to not contribute any preemphasis to the data signal. In another example, the user may configure preemphasis driver 304 to contribute preemphasis to the data signal that is a certain percentage of the voltage swing of the data signal. It should be understood by one skilled in the art that a deemphasis driver may be used instead of preemphasis driver 304.

It may be difficult for primary driver 302 to generate data signals with 50/50 duty cycles. One of the reasons it is difficult for primary driver 302 to generate data signals with 50/50 duty cycles is that primary driver 302 supports a wide range of data rates. Another reason it is difficult for primary driver 302 to generate data signals with 50/50 duty cycles is that primary driver 302 is configured to be compatible with a wide variety of customer links.

To correct the duty cycles of data signals generated by primary driver 304, the outputs of primary driver 302 and preemphasis driver 304 may be combined and routed to programmable duty cycle circuitry 306a and 306b to allow programmable duty cycle circuitry 306a and 306b to process the combined signal. In some embodiments, programmable duty cycle circuitry 306a and 306b may be implemented as a single circuit. In some embodiments, if the data signal transmitted by driver 102 (FIG. 1) is single-ended, only one of programmable duty cycle circuitry 306a and 306b may be used to adjust the duty cycle of the data signal.

Programmable duty cycle circuitry 306a and 306b may perform duty cycle adjustment by adjusting the falling and rising edges of the positive and negative legs of the data signal. In this approach, the falling and rising edges of the data signal may be independently controlled by programmable duty cycle circuitry 306a and 306b, which allows four adjustments to the duty cycle of the data signal to be made.

For example, referring to data signal 250 (FIG. 2B), programmable duty cycle circuitry 306a and 306b may adjust the falling edges of the positive and negative legs outward (i.e., to the right) until the duty cycle of data signal 250 is 50/50. In another example, programmable duty cycle circuitry 306a and 306b may adjust the rising edges of the positive and negative legs inwards (i.e., to the left) until the duty cycle of data signal 250 is 50/50.

In some embodiments, programmable duty cycle circuitry 306a and 306b performs rising edge and falling edge adjustment of the data signal by delaying the rising edges of the data signal with respect to the falling edges or vice versa. In some embodiments, rising and falling edge adjustments to the data signal may be provided as part of buffer slew rate control logic (not shown), which controls the slope of the rising and falling edges.

In some embodiments, programmable duty cycle circuitry 306a and 306b may dynamically control the amount of duty cycle adjustment as a function of the characteristics of the data signal. For example, programmable duty cycle circuitry 306a and 306b may provide different amounts of duty cycle adjustment to data signals having different amounts of preemphasis to account for the different amounts of preemphasis. In another example, programmable duty cycle circuitry 306a and 306b may provide different amounts of duty cycle adjustment to data signals having different data rates to account for the different data rates. In another example, programmable duty cycle circuitry 306a and 306b may provide different amounts of duty cycle adjustment to data signals having different voltage swings to account for the different voltage swings.

In some embodiments, programmable duty cycle circuitry 306a and 306b may be compatible with legacy drivers that operate at higher power supply voltages as well as newer drivers that operate at lower power supply voltages.

Programmable duty cycle circuitry 306a and 306b may be configured to adjust the duty cycle of data signals to adapt to imperfections in receiver 106 (FIG. 1). For example, receiver 106 may prefer to receive data signals with a 45/55 duty cycle (i.e., the bit error rate is at a minimum when receiver 106 receives data signals with 45/55 duty cycles). Accordingly, in this example, programmable duty cycle circuitry 306a and 306b may be configured to adjust the duty cycles of data signals to be 45/55.

Similarly, programmable duty cycle circuitry 306a and 306b may be configured to compensate for duty cycle distortion caused by process variations in driver 102 that prevent driver 102 from generating data signals with duty cycles of 50/50.

In addition to duty cycle adjustment, programmable duty cycle circuitry 306a and 306b may also provide common mode adjustment to data signals. For example, programmable duty cycle circuitry 306a and 306b may shift the V_{OL} and V_{OH} limits of data signals upwards or downwards. This approach is especially useful in DC-coupled systems because the crossover of the data signal may be adjusted to match the sampling point of the receiver and improve the bit error rate.

In some embodiments, primary driver 302 and preemphasis driver 304 may each include associated programmable duty cycle adjustment circuitry. In this approach, the duty cycles of the data signal and the preemphasis signal may be adjusted separately, allowing the duty cycle of the combined signal to be adjusted with greater precision.

Memory elements 308a and 308b may be coupled to programmable duty cycle circuitry 306a and 306b, respectively. Memory elements 308a and 308b may store control signals to control the amount of duty cycle adjustment provided to the data signal by programmable duty cycle circuitry 306a and 306b. Memory elements 308a and 308b may be configuration RAM cells, fuse-based devices, antifuses, programmable-erasable-read-only memories (PROMS), erasable PROMS (EPROMS), electrically-erasable PROMS (EEPROMS), flash memory, and any other suitable memory element. In some embodiments, the control signals may be fixed-length digital words. In some embodiments, the control signals may be analog signals. In some embodiments, memory elements 308a and 308b may be bypassed to provide control signals directly into programmable duty cycle circuitry 306a and 306b.

In some embodiments, the value of the control signals is determined by end-users. For example, the end-user may measure the data signal output by driver 102 (FIG. 1) and determine the amount of duty cycle adjustment necessary to adjust the duty cycle of the data signal to be 50/50. In another example, if the data signal output by driver 102 includes preemphasis, the end-user may measure the data signal at receiver 106 (FIG. 1) and determine a suitable amount of duty cycle adjustment to provide to the data signal. In the preceding examples, the user may utilize calibration circuitry to determine the appropriate control signals to store in memory elements 308a and 308b. In another example, the end-user may operate a digital bit-error rate counter at receiver 106 (FIG. 1) and determine the control signals to store in memory elements 308a and 308b that produce the lowest bit-error rate.

In some embodiments, programmable duty cycle circuitry 306a and 306b may utilize negative feedback to determine the amount of duty cycle adjustment to provide the data signal. For example, the output of backplane 104 (FIG. 1) may be coupled to a buffer and fed back to programmable duty cycle circuitry 306a and 306b. Programmable duty cycle circuitry 306a and 306b may adjust the duty cycle of the data signal based on the feedback signal. In this example, the feedback signal may or may not be provided to memory elements 308a and 308b.

It should be understood by one skilled in the art that instead of adjusting the duty cycle of data signals output by primary driver 302 and preemphasis driver 304, programmable duty cycle circuitry 306a and 306b may adjust the duty cycle of a data signal before it is input into primary driver 302 and preemphasis driver 304. That is, programmable duty cycle adjustment circuitry 306a and 306b may be implemented before primary driver 302 and preemphasis driver 304 without departing from the principles of the present invention.

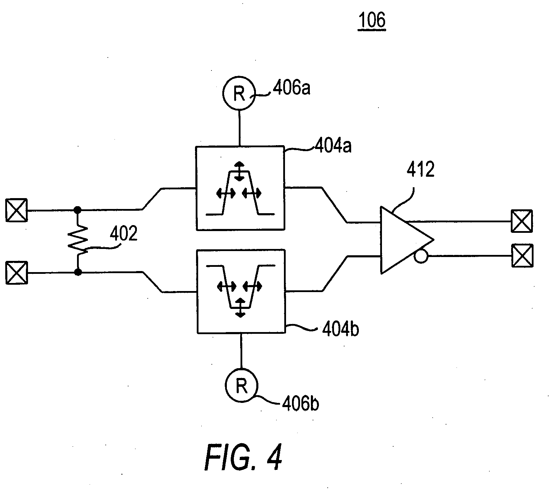

FIG. 4 is a block diagram of an illustrative receiver 106 that has the capability to adjust the duty cycles of data signals in accordance with the present invention. Receiver 106 may include termination resistor 402, programmable duty cycle adjustment circuitry 404a and 404b, memory elements 406a and 406b, and receiver buffer 412. In some embodiments, receiver circuitry 106 includes equalization circuitry (not shown) and clock data recovery (CDR) circuitry (not shown).

Termination resistor 402 may be provided in parallel between the input pins of receiver circuitry 106. The resistance of termination resistor 402 may be programmable to provide impedance matching with transmission medium 104 (FIG. 1).

Programmable duty cycle adjustment circuitry 404a and 404b are substantially identical to programmable duty cycle adjustment circuitry 306a and 306b (FIG. 3). As stated earlier, programmable duty cycle adjustment circuitry may be implemented on driver 102 and/or receiver 106. However, programmable duty cycle adjustment circuitry 306a and 306b process data signals prior to traveling across transmission medium 104 (FIG. 1), whereas programmable duty cycle adjustment circuitry 404a and 404b process data cycles after having traveled across transmission medium 104. Therefore, the data signals processed by programmable duty cycle adjustment circuitry 404a and 404b have already undergone duty cycle distortion, whereas the data signals processed by programmable duty cycle adjustment circuitry 306a and 306b are only distorted to the extent driver 102 (FIG. 1) is unable to create data signals with 50/50 duty cycles.

Memory elements 406a and 406b are substantially identical to memory elements 308a and 308b (FIG. 3). Memory elements 406a and 406b store control signals for controlling programmable duty cycle adjustment circuitry 404a and 404b to correct the duty cycle of received data signals to be 50/50. The control signals may be determined by end-users (e.g., through measurements and/or calibrations) or dynamically (e.g., by implementing negative feedback loops).

It should be understood by one skilled in the art that instead of adjusting the duty cycle of data signals before it being processed by receiver buffer 412, programmable duty cycle circuitry 404a and 404b may adjust the duty cycle of a data signal after it is processed by receiver buffer 412. That is, programmable duty cycle adjustment circuitry 404a and 404b may be implemented after receiver buffer 412 without departing from the principles of the present invention.

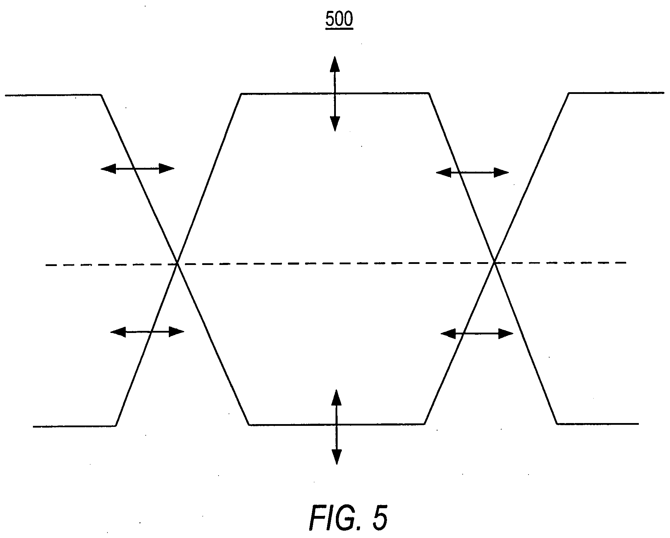

FIG. 5 is a diagram that illustrates the ability of programmable duty cycle adjustment circuitry to adjust a data signal 500 in accordance with the present invention.

As shown in FIG. 5, the positive and negative legs of data signal 500 may be adjusted in several ways. In particular, the rising edge of each leg may be adjusted inwards and outwards. The falling edge of each leg may be adjusted inwards and outwards. The common mode level of each leg may be adjusted upwards and downwards. In some embodiments, the amount of adjustment provided to each leg may be determined by the user. In some embodiments, the amount of adjustment provided to each leg may be determined through the use of a negative feedback loop.

There may be physical and/or practical limitations on the amount of duty cycle and common mode adjustment provided by programmable duty cycle adjustment circuitry. The amount of common mode level adjustment may be limited by the power supply voltages of either the driver or receiver. For example, the common mode level may be adjusted to the extent that V_{OH} and V_{OL} do not exceed any of the power supply voltages. The amount of duty cycle adjustment may be limited by the clock period of data signal 500. For example, the amount of duty cycle adjustment for each rising and falling edge may be limited to half of a clock period.

Although the present invention has been discussed in the context of providing programmable duty cycle adjustment to differential data signals, it should be understood by one skilled in the art that the principles of this invention could be applied to serial data transmission systems utilizing single-ended-data-signals.

## Claims

1. A method for programmably adjusting on a driver (102) or on a receiver (106) the duty cycle of a serial data transmission of a data signal that travels across a transmission medium (104), comprising:
adjusting rising and falling edges of a positive leg of the data signal by a first programmable duty cycle circuitry (306a, 404a) by an amount controlled by a first control signal as output by a first memory element (308a, 406a); and
adjusting rising and falling edges of a negative leg of the data signal by a second programmable duty cycle circuitry (306b, 404b) by an amount controlled by a second control signal;
**characterized by**
programming the first memory element (308a, 406a) with the first control signal;
programming a second memory element (308b, 406b) with the second control signal;
providing the first control signal from the first memory element (308a, 406a) to the first programmable duty cycle circuitry (306a, 404a); and
providing the second control signal from the second memory element (308b, 406b) to the second programmable duty cycle circuitry (306b, 404b);
wherein end-users determine the amounts of adjustment of the rising and falling edges of the positive and negative legs.

2. The method of claim 1, wherein the data signal is adjusted to have a 50/50 duty cycle.

3. The method of claim 1, wherein the data signal is adjusted to have a duty cycle preferred by receiver circuitry.

4. The method of claim 1, wherein the data signal includes preemphasis or deemphasis.

5. The method of claim 1, wherein the adjusting of the rising and falling edges of the positive and negative legs of the data signal is performed prior to being transmitted over the transmission medium.

6. The method of claim 1, wherein the adjusting of the rising and falling edges of the positive and negative legs of the data signal is performed after being received from the transmission medium.

7. The method of claim 1, further comprising adjusting the common mode level of the positive and negative legs of the data signal.

8. The method of claim 7, wherein the amount of common mode level adjustment is determined by end-users.

9. Circuitry for programmably adjusting on a driver (102) or on a receiver (106) the duty cycle of a serial data transmission of a data signal that travels across a transmission medium (104), comprising:
a first programmable duty cycle circuitry (306a, 404a) for adjusting rising and falling edges of a positive leg of the data signal by an amount controlled by a first control signal;
a second programmable duty cycle circuitry (306b, 404b) for adjusting rising and falling edges of a negative leg of the data signal by an amount controlled by a second control signal;
**characterized by**
a first memory element (308a, 406a) for programmably storing the first control signal; and
a second memory element (308b, 406b) for programmably storing the second control signal;
wherein the first programmable duty cycle circuitry (306a, 404a) is adapted to receive the first control signal from the first memory element (308a, 406a);
wherein the second programmable duty cycle circuitry (306b, 404b) is adapted to receive the second control signal from the second memory element (308b, 406b); and
wherein end-users determine the amounts of adjustment of the rising and falling edges of the positive and negative legs.

10. The circuitry of claim 9, wherein the first and second programmable duty cycle circuitries adjust the data signal to have a 50/50 duty cycle.

11. The circuitry of claim 9, wherein the first and second programmable duty cycle circuitries adjust the data signal to have a duty cycle preferred by receiver circuitry.

12. The circuitry of claim 9, wherein the data signal includes preemphasis or deemphasis.

13. The circuitry of claim 9, wherein the first and second programmable duty cycle circuitries are implemented on a driver that is configured to transmit the data signal across the transmission medium.

14. The circuitry of claim 9, wherein the first and second programmable duty cycle circuitries are implemented on a receiver that is configured to receive the data signal from the transmission medium.

15. The circuitry of claim 9, further comprising a third circuit element configured to adjust the common mode level of the positive and negative legs of the data signal.

16. The circuitry of claim 15, wherein end-users determine the amount of common mode level adjustment.

## Patentansprüche

1. Verfahren zum programmierbaren Einstellen des Tastverhältnisses einer seriellen Datenübertragung eines Datensignals, das ein Übertragungsmedium (104) durchquert, an einem Treiber (102) oder an einem Empfänger (106), umfassend:
Einstellen von ansteigenden und fallenden Flanken eines positiven Zweigs des Datensignals durch einen ersten programmierbaren Tastverhältnisschaltkreis (306a, 404a) um einen Betrag, der durch ein erstes Steuersignal gesteuert wird, das durch ein erstes Speicherelement (308a, 406a) ausgegeben wird; und
Einstellen von ansteigenden und fallenden Flanken eines negativen Zweigs des Datensignals durch einen zweiten programmierbaren Tastverhältnisschaltkreis (306b, 404b) um einen Betrag, der durch ein zweites Steuersignal gesteuert wird;
**gekennzeichnet durch**
Programmieren des ersten Speicherelements (308a, 406a) mit dem ersten Steuersignal;
Programmieren eines zweiten Speicherelements (308b, 406b) mit dem zweiten Steuersignal;
Leiten des ersten Steuersignals von dem ersten Speicherelement (308a, 406a) zu dem ersten programmierbaren Tastverhältnisschaltkreis (306a, 404a); und
Leiten des zweiten Steuersignals von dem zweiten Speicherelement (308b, 406b) zu dem zweiten programmierbaren Tastverhältnisschaltkreis (306b, 404b);
wobei Endbenutzer die Einstellungsbeträge der ansteigenden und fallenden Flanken der positiven und negativen Zweige bestimmen.

2. Verfahren nach Anspruch 1, wobei das Datensignal so eingestellt wird, dass es ein Tastverhältnis von 50/50 aufweist.

3. Verfahren nach Anspruch 1, wobei das Datensignal so eingestellt wird, dass es ein Tastverhältnis aufweist, das durch Empfängerschaltkreise bevorzugt wird.

4. Verfahren nach Anspruch 1, wobei das Datensignal Preemphase oder Deemphase umfasst.

5. Verfahren nach Anspruch 1, wobei das Einstellen der ansteigenden und fallenden Flanken der positiven und negativen Zweige des Datensignals vor der Übertragung über das Übertragungsmedium durchgeführt wird.

6. Verfahren nach Anspruch 1, wobei das Einstellen der ansteigenden und fallenden Flanken der positiven und negativen Zweige des Datensignals nach dem Empfang von dem Übertragungsmedium durchgeführt wird.

7. Verfahren nach Anspruch 1, das ferner Einstellen des Gleichtaktpegels der positiven und negativen Zweige des Datensignals umfasst.

8. Verfahren nach Anspruch 7, wobei der Betrag der Gleichtaktpegeleinstellung durch Endbenutzer bestimmt wird.

9. Schaltkreis zum programmierbaren Einstellen des Tastverhältnisses einer seriellen Datenübertragung eines Datensignals, das ein Übertragungsmedium (104) durchquert, an einem Treiber (102) oder an einem Empfänger (106), umfassend:
einen ersten programmierbaren Tastverhältnisschaltkreis (306a, 404a) zum Einstellen von ansteigenden und fallenden Flanken eines positiven Zweigs des Datensignals um einen Betrag, der durch ein erstes Steuersignal gesteuert wird;
einen zweiten programmierbaren Tastverhältnisschaltkreis (306b, 404b) zum Einstellen von ansteigenden und fallenden Flanken eines negativen Zweigs des Datensignals um einen Betrag, der durch ein zweites Steuersignal gesteuert wird;
**gekennzeichnet durch**:
ein erstes Speicherelement (308a, 406a) zum programmierbaren Speichern des ersten Steuersignals; und
ein zweites Speicherelement (308b, 406b) zum programmierbaren Speichern des zweiten Steuersignals;
wobei der erste programmierbare Tastverhältnisschaltkreis (306a, 404a) dafür ausgelegt ist, das erste Steuersignal von dem ersten Speicherelement (308a, 406a) zu empfangen;
wobei der zweite programmierbare Tastverhältnisschaltkreis (306b, 404b) dafür ausgelegt ist, das zweite Steuersignal von dem zweiten Speicherelement (308b, 406b) zu empfangen; und
wobei Endbenutzer die Einstellungsbeträge der ansteigenden und fallenden Flanken der positiven und negativen Zweige bestimmen.

10. Schaltkreis nach Anspruch 9, wobei der erste und zweite programmierbare Tastverhältnisschaltkreis das Datensignal so einstellen, dass es ein Tastverhältnis von 50/50 aufweist.

11. Schaltkreis nach Anspruch 9, wobei der erste und zweite programmierbare Tastverhältnisschaltkreis das Datensignal so einstellen, dass es ein durch Empfängerschaltkreise bevorzugtes Tastverhältnis aufweist.

12. Schaltkreis nach Anspruch 9, wobei das Datensignal Preemphase oder Deemphase umfasst.

13. Schaltkreis nach Anspruch 9, wobei der erste und zweite programmierbare Tastverhältnisschaltkreis an einem Treiber implementiert sind, der dafür ausgelegt ist, das Datensignal über das Übertragungsmedium zu übertragen.

14. Schaltkreis nach Anspruch 9, wobei der erste und zweite programmierbare Tastverhältnisschaltkreis an einem Empfänger implementiert sind, der dafür ausgelegt ist, das Datensignal von dem Übertragungsmedium zu empfangen.

15. Schaltkreis nach Anspruch 9, der ferner ein drittes Schaltungselement umfasst, das dafür ausgelegt ist, den Gleichtaktpegel der positiven und negativen Zweige des Datensignals einzustellen.

16. Schaltkreis nach Anspruch 15, wobei Endbenutzer den Betrag der Gleichtaktpegeleinstellung bestimmen.

## Revendications

1. Procédé d'ajustement de façon programmable sur un pilote (102) ou sur un récepteur (106) du cycle de service d'une transmission de données en série d'un signal de données qui se déplace à travers un support de transmission (104), comprenant :
l'ajustement de fronts montants et descendants d'un tronçon positif du signal de données par une première circuiterie de cycle de service programmable (306a, 404a) d'une quantité commandée par un premier signal de commande en sortie par un premier élément de mémoire (308a, 406a) ; et
l'ajustement de fronts montants et descendants d'un tronçon négatif du signal de données par une seconde circuiterie de cycle de service programmable (306b, 404b) d'une quantité commandée par un second signal de commande ;
**caractérisé par**
la programmation du premier élément de mémoire (308a, 406a) avec le premier signal de commande ;
la programmation d'un second élément de mémoire (308b, 406b) avec le second signal de commande ;
la fourniture du premier signal de commande provenant du premier élément de mémoire (308a, 406a) à la première circuiterie de cycle de service programmable (306a, 404a) ; et
la fourniture du second signal de commande provenant du second élément de mémoire (308b, 406b) à la seconde circuiterie de cycle de service programmable (306b, 404b) ;
dans lequel des utilisateurs finaux déterminent les quantités d'ajustement des fronts montants et descendants des tronçons positif et négatif.

2. Procédé selon la revendication 1, dans lequel le signal de données est ajusté pour avoir un cycle de service de 50/50.

3. Procédé selon la revendication 1, dans lequel le signal de données est ajusté pour avoir un cycle de service préféré par une circuiterie de récepteur.

4. Procédé selon la revendication 1, dans lequel le signal de données comporte une préaccentuation ou une désaccentuation.

5. Procédé selon la revendication 1, dans lequel l'ajustement des fronts montants et descendants des tronçons positif et négatif du signal de données est réalisé avant qu'il soit transmis sur le support de transmission.

6. Procédé selon la revendication 1, dans lequel l'ajustement des fronts montants et descendants des tronçons positif et négatif du signal de données est réalisé après qu'il a été reçu en provenance du support de transmission.

7. Procédé selon la revendication 1, comprenant en outre l'ajustement du niveau de mode commun des tronçons positif et négatif du signal de données.

8. Procédé selon la revendication 7, dans lequel la quantité d'ajustement de niveau de mode commun est déterminée par des utilisateurs finaux.

9. Circuiterie d'ajustement de façon programmable sur un pilote (102) ou sur un récepteur (106) du cycle de service d'une transmission de données en série d'un signal de données qui se déplace à travers un support de transmission (104), comprenant :
une première circuiterie de cycle de service programmable (306a, 404a) pour ajuster des fronts montants et descendants d'un tronçon positif du signal de données d'une quantité commandée par un premier signal de commande ;
une seconde circuiterie de cycle de service programmable (306b, 404b) pour ajuster des fronts montants et descendants d'un tronçon négatif du signal de données d'une quantité commandée par un second signal de commande ;
**caractérisée par**
un premier élément de mémoire (308a, 406a) pour stocker de façon programmable le premier signal de commande ;
un second élément de mémoire (308b, 406b) pour stocker de façon programmable le second signal de commande ;
dans laquelle la première circuiterie de cycle de service programmable (306a, 404a) est adaptée pour recevoir le premier signal de commande en provenance du premier élément de mémoire (308a, 406a) ;
dans laquelle la seconde circuiterie de cycle de service programmable (306b, 404b) est adaptée pour recevoir le second signal de commande en provenance du second élément de mémoire (308b, 406b) ; et
dans laquelle des utilisateurs finaux déterminent les quantités d'ajustement des fronts montants et descendants des tronçons positif et négatif.

10. Circuiterie selon la revendication 9, dans laquelle les première et seconde circuiteries de cycle de service programmable ajustent le signal de données pour qu'il ait un cycle de service de 50/50.

11. Circuiterie selon la revendication 9, dans laquelle les première et seconde circuiteries de cycle de service programmable ajustent le signal de données pour qu'il ait un cycle de service préféré par une circuiterie de récepteur.

12. Circuiterie selon la revendication 9, dans laquelle le signal de données comporte une préaccentuation ou une désaccentuation.

13. Circuiterie selon la revendication 9, dans laquelle les première et seconde circuiteries de cycle de service programmable sont implémentées sur un pilote qui est configuré pour transmettre le signal de données à travers le support de transmission.

14. Circuiterie selon la revendication 9, dans laquelle les première et seconde circuiteries de cycle de service programmable sont implémentées sur un récepteur qui est configuré pour recevoir le signal de données en provenance du support de transmission.

15. Circuiterie selon la revendication 9, comprenant en outre un troisième élément de circuit configuré pour ajuster le niveau de mode commun des tronçons positif et négatif du signal de données.

16. Circuiterie selon la revendication 15, dans laquelle des utilisateurs finaux déterminent la quantité d'ajustement de niveau de mode commun.
